Europäisches Patentamt

European Patent Office

Office européen des brevets

(11) Numéro de publication: **0 130 650 B1**

# FASCICULE DE BREVET EUROPEEN

(45) Date de publication de fascicule du brevet: **12.08.92** (51) Int. Cl.5: **G02B 6/12**

(21) Numéro de dépôt: **84200940.9**

(22) Date de dépôt: **29.06.84**

(54) **Dispositif semi-conducteur comportant un guide d'onde lumineuse et procédé de réalisation d'un tel dispositif.**

(30) Priorité: **01.07.83 FR 8311007**

(43) Date de publication de la demande:
**09.01.85 Bulletin 85/02**

(45) Mention de la délivrance du brevet:
**12.08.92 Bulletin 92/33**

(84) Etats contractants désignés:
**DE FR GB NL SE**

(56) Documents cités:
FR-A- 2 168 936      FR-A- 2 336 797
US-A- 3 425 879      US-A- 3 984 173
US-A- 4 066 482      US-A- 4 099 305
US-A- 4 116 530

APPLIED PHYSICS LETTERS, vol. 25, no. 2, 15 juillet 1974, pages 116-118, New York, USA; F.A. BLUM et al.: "Optical striplines for integrated optical circuits in epitaxial GaAs"

APPLIED OPTICS, vol. 14, no. 5, mai 1975, pages 1200-1206, New York, USA; WON-TIEN TSANG et al.: "Optical waveguides fabricated by preferential etching"

(73) Titulaire: **ALCATEL ALSTHOM RECHERCHE Société Anonyme Route de Nozay 91460 Marcoussis(FR)**

(72) Inventeur: **Erman, Marco Société Civile S.P.I.D. 209 rue de l'Université F-75007 Paris(FR)**
Inventeur: **Vodjdani, Nakita Société Civile S.P.I.D. 209 rue de l'Université F-75007 Paris(FR)**
Inventeur: **Theeten, Jean-Bernard Société Civile S.P.I.D. 209 rue de l'Université F-75007 Paris(FR)**

(74) Mandataire: **Dalsace, Michel et al c/o Sospi 14-16, rue de la Baume F-75008 Paris(FR)**

Rank Xerox (UK) Business Services

JOURNAL OF CRYSTAL GROWTH, vol. 13/14, mai 1972, pages 336-341, Amsterdam, NL; S. IIDA et al.: "Morphological studies on selective growth of GaAs"

APPLIED PHYSICS LETTERS, vol. 30, no. 6, 15 mars 1977, pages 293-296, American Institute of Physics; New York, USA; W.T. TSANG et al.: "Growth of GaAs-Ga1-xAlxAs over preferentially etched channels by molecular beam epitaxy: A technique for two-dimensional thin-film definition"

APPLIED PHYSICS LETTERS, vol. 38, no. 5, 1 mars 1981, pages 313-315, American Institute of Physics, New York, USA; F.J. LEONBERGER et al.: "Low-loss GaAs optical waveguides formed by lateral epitaxial growth over oxide"

APPLIED PHYSICS LETTERS, vol. 24, no.9, mai 1974, pp 430-432

APPLIED PHYSICS LETTERS, vol. 27, no. 7, octobre 1975, pp 405-407

APPLIED PHYSICS LETTERS, vol. 27, no. 9, novembre 1975, pp 510-511

APPLIED PHYSICS LETTERS, vol. 28, no. 4, février 1976, pp 234-236

JOURNAL OF CRYSTAL GROWTH,13/14, 1972, pp 325-330

REVIEW OF MODERN PHYSICS, vol. 49, no. 2, avril 1977, pp 361 et 401 à 407

Book "GALLIUM ARSENIDE PROCESSING TECHNIQUES", R.E. Williams, 1984, pp 42, 43

## Description

L'invention concerne un dispositif semiconducteur incluant un guide de lumière intégré, ce dispositif comprenant un substrat semiconducteur monocristallin ayant une surface orientée selon un plan cristallographique, recouverte d'une couche diélectrique munie d'une ouverture en forme de rainure parallèle à une direction cristallographique du substrat, ladite ouverture étant prolongée dans le substrat par un sillon ayant au moins une paroi formée par une facette cristallographique, et ledit dispositif comprenant en outre pour constituer le guide de lumière un ruban épitaxial monocristallin semiconducteur réalisé par croissance à partir de la facette cristallographique du sillon, ledit ruban ayant une forme prismatique d'axe parallèle à la direction du sillon et des faces qui sont, des facettes cristallographiques naturelles de croissance du ruban épitaxial.

L'invention concerne également un procédé de réalisation d'un tel guide d'onde.

Cette invention trouve son application d'une part dans la réalisation du couplage des fibres optiques conventionnelles et des circuits intégrés de détection ou d'émission et d'autre part dans la connectique optique en micro-optoélectronique.

Il est connu de l'état de la technique de former un dispositif semiconducteur optoélectronique intégré, du type laser, par la publication intitulée "Embedded heterostructure epitaxy : A technique for two-dimensional thin-film definition". par I. Samid et alii dans "Applied Physics Letters, Vol.27, N°7, October 1, 1975, p.405-407". Ce document décrit un dispositif laser intégré constitué d'une structure multicouches de GaAs-GaAlAs réalisée dans une ouverture en forme de rainure pratiquée dans une couche de $Al_2O_3$ déposée à la surface supérieure d'un substrat en GaAs monocristallin orienté. La rainure est orientée selon un axe cristallographique du substrat et, préalablement à la réalisation du multicouches, la surface du substrat qui apparaît dans la rainure subit une légère gravure. La structure multicouches est réalisée par croissance épitaxiale en phase liquide, et résulte en un ruban plat, c'est-à-dire de faible dimension perpendiculairement au substrat, et allongé, de forme prismatique, qui s'étend en surface du substrat dans l'ouverture en forme de rainure. Les faces du prisme sont constituées par les facettes cristallographiques de croissance des couches épitaxiales et elles dépendent de l'orientation cristallographique de la rainure. Ce document enseigne que ces faces sont très réfléchissantes et appropriées à améliorer l'effet laser.

Il est par ailleurs connu de la publication intitulée "Etude de l'épitaxie localisée du GaAs" dans Journal of Crystal Growth 13/14 (1972) pp.325-330, de réaliser des couches par la méthode d'épitaxie en phase vapeur, dans l'ouverture d'un masque, et après décapage ou gravure anisotrope à travers cette ouverture. Cette méthode permet d'obtenir des couches parfaitement anisotropes et dotées de facettes cristallographiques naturelles de croissance qui dépendent fortement de la profondeur de la gravure anisotrope avant la croissance.

Ce document enseigne que par la croissance épitaxiale en phase vapeur, on peut réaliser des rubans prismatiques dans des rainures aussi étroites que 3 $\mu$m de dimensions transversales.

Il est en outre connu de la publication intitulée "Optically pumped GaAs mesa surface laser" par F.A Blum et alii, dans "Applied Physics Letters Vol.24, N°9, 1 May 1974, p.430-432" de réaliser un dispositif LASER semiconducteur intégré. Ce dispositif comprend des structures MESA en forme de losange, présentant des faces verticales perpendiculaires au substrat. Ce dispositif a environ 16 $\mu$m de haut, et 300 $\mu$m x 700 $\mu$m pour les diagonales du losange. Ce dispositif est réalisé par croissance épitaxiale en phase vapeur sur un substrat orienté. Un masque en $SiO_2$ est réalisé sur ce substrat et une ouverture en forme de losange est gravée avec les flancs parallèles aux plans cristallographiques (111). La structure laser est réalisée en surface du substrat dans cette ouverture par la croissance en phase vapeur.

Mais aucun de ces documents n'enseigne à réaliser des rubans de forme et dimensions appropriées à constituer des guides de lumière et en outre munis de moyens de confinement.

En particulier, tous ces documents concernent des dispositifs de sensiblement même dimension transversale que les ouvertures pratiquées dans la couche diélectrique.

Il est encore connu de l'état de la technique de réaliser des guides de lumière en matériaux III-V par épitaxie à partir de sillons. On citera à cet effet la publication intitulée "Growth characteristics of GaAs-$Ga_{1-x}Al_xAs$ Structures fabricated by liquid-phase epitaxy over preferentially etched channels", dans Applied Physics Letters, Vol.28, N°4, 15 February 1976, pp.234-237. Ce document concerne la réalisation, par la méthode dite croissance épitaxiale en phase liquide, de couches épitaxiales de GaAs et GaAlAs dans des sillons réalisés par gravure anisotrope dans un substrat en GaAs. Ce document enseigne que "le remplissage des sillons est dicté par la tension superficielle du bain plutôt que par la croissance préférentielle à partir des plans cristallographiques formant les flancs du sillon d'origine. Ces caractéristiques de croissance font que le profil final des couches épitaxiales dépend peu du profil initial du sillon gravé".

Les photographies présentées dans le document cité, montrent que le fond du sillon est totalement arrondi et que la partie supérieure des couches est dénuée de facettes.

Or pour les applications envisagées, le problème technique est la mise au point d'un dispositif permettant à la fois la réalisation de circuits intégrés ultrarapides, et la propagation de la lumière avec une faible atténuation. Des études ont montré que l'atténuation idéale ne doit pas dépasser 1 dB/cm pour une longueur d'onde de 1,06 $\mu$m.

Pour diminuer les pertes le long des parois externes du guide dues à un mauvais état de surface qui engendre des pertes par diffusion, un des buts de l'invention est de fournir un dispositif semiconducteur muni d'un guide de lumière dont les parois externes sont constituées par des facettes cristallographiques de croissance afin d'obtenir la réflexion totale de la lumière sur ces facettes et d'améliorer ainsi le confinement latéral.

D'après le document cité précédemment, en outre, la dimension traversale des sillons gravés et donc des guides obtenus, est de l'ordre de 30 à 100 $\mu$m, ce qui est incompatible avec l'application envisagée par l'invention du couplage du dispositif semiconducteur muni de guides de lumière, avec des fibres optiques traditionnelles, ces dernière présentant des dimensions bien inférieures.

Un des buts de l'invention est donc de fournir un dispositif semiconducteur muni d'un guide de lumière adapté au mieux à ce couplage et donc doté de faibles dimensions de l'ordre de celles des fibres, ainsi que d'une forme se rapprochant de celle des fibres.

On notera qu'il est cependant connu de la publication intitulée "Etched buried heterostructure GaAs/GaAlAs injection lasers" dans Applied Physics Letters Vol.27, N°9, pp.510-511, de réaliser des couches épitaxiales en phase liquide dans des sillons de petites dimensions de l'ordre de 3 $\mu$m. Mais cette publication enseigne qu'en dépit des précautions prises durant la croissance, notamment en pratiquant une croissance extrêmement lente, la première couche déposée présente des défauts dus à un mauvais mouillage des flancs du sillon. Les photographies présentées dans ce document montrent que, du fait de la croissance LPE, les flancs du sillon, qui présentaient initialement des plans cristallographiques, sont devenus arrondis, et le texte précise qu'outre les difficultés de croissance provoquées par le défaut de mouillage dû à l'étroitesse des sillons, la surface supérieure finale des couches est planaire.

La réalisation de guides de lumière par épitaxie est encore connue de la publication intitulée "Growth of GaAs-Ga$_{1-x}$Al$_x$ As over preferentially etched channels by molecular beam epitaxy : A technique for two-dimensional thin-film definition", dans Applied Physics Letters, Vol.30, N°6, 15 mars 1977, pp.293-296. Selon le document cité, on pourrait obtenir, par une méthode de croissance par jet moléculaire (MBE) "un guide de lumière formé par des couches disposées dans un sillon gravé anisotropiquement, ces couches présentant des facettes cristallographiques polies et hautement réfléchissantes".

Cependant, les photographies présentées dans le document cité, montrent que le pourtour des couches est arrondi et irrégulier. L'homme du métier saît aussi à ce jour que la MBE ne permet ni la croissance localisée, ni la croissance anisotrope. Selon ce document, également, les sillons sont larges, d'environ 20 $\mu$m.

L'homme du métier ne peut donc tirer du document cité un enseignement pour résoudre les problèmes techniques cités précédemment.

Il est encore connu de l'état de la technique de réaliser des guides de lumière par croissance épitaxiale délimitée par une rainure pratiquée dans une couche diélectrique. Un tel dispositif est notamment décrit dans le brevet des Etats-Unis N° 3 984 173. Ce document concerne une structure de guide obtenue par croissance épitaxiale en phase vapeur à partir d'un substrat monocristallin orienté, dans l'ouverture d'un masque orienté selon une direction cristallographique, ouverture qui présente exactement les mêmes dimensions au niveau du substrat que le guide. Dans certaines formes de réalisation, le substrat présente avec le matériau du guide une différence d'indice permettant un certain confinement.

Un des buts de l'invention est d'obtenir une meilleure isolation optique entre le guide et le substrat, ou entre le guide et le milieu extérieur.

Un autre dispositif incluant un guide de lumière est aussi connu par la publication de F.J. Leonberger et alii dans Applied Physics Letters 38(5) du 1er mars 1981, pages 313 à 315 intitulée "Low-loss GaAs optical waveguides formed by lateral epitaxial growth over oxide". Ce document décrit un procédé de réalisation de guides d'onde sur un substrat monocristallin d'arséniure de gallium, recouvert d'une couche d'oxyde de silicium SiO$_2$. Par gravure, des fenêtres sont ouvertes dans cette couche, fenêtres dans lesquelles est formée, par croissance épitaxiale, en phase vapeur une couche d'arséniure de gallium monocristallin dopé n$^-$. Au début de la croissance, la couche de GaAs-n$^-$ part de l'amorce constituée par le substrat dans l'ouverture des fenêtres, puis lorsque la couche épitaxiale épaissit, elle déborde sur les côtés des fenêtres, pour finir par réaliser, au-dessus de la totalité de la couche de SiO$_2$, une couche uniforme de GaAs monocristallin dopé n$^-$. Après réalisation de cette couche de GaAs, les guides d'onde sont formés par gravure de cette dernière et présentent la forme d'un ruban en relief de section rectangulaire. Grâce à la sous-couche en oxyde de silicium SiO$_2$,

les pertes le long d'un guide de ce type sont assez faibles et l'atténuation le long d'un tel guide est de l'ordre de 2,3 dB/cm à 1,06 $\mu$m.

Cependant la lumière propagée dans un tel guide est mal confinée par les parois latérales. En effet, ces guides étant gravés dans la couche d'arséniure de gallium, mais non pas jusqu'à la couche de silice (SiO$_2$), ne présentent pas d'interface air-arséniure de gallium (GaAs) sur toute la hauteur des faces latérales verticales, mais seulement sur une partie. Or, si l'interface air-arséniure de gallium (GaAs) sur la face supérieure du guide permet une très bonne réflexion totale du fait de la différence d'indice entre l'air et l'arséniure de gallium (GaAs) $\Delta n \simeq 2,5$, au contraire, le fait qu'il n'y ait pas d'interfaces entre le guide et la couche d'arséniure de gallium (GaAs) continue proprement dite entraîne des pertes le long des parois longitudinales latérales du guide. D'autre part, les parois latérales et supérieures, obtenues par le traitement chimique de gravure, présentent une surface dépolie. Cet état de surface engendre également des pertes.

Ces Pertes sont encore plus accentuées lorsque l'on veut donner au guide un rayon de courbure, afin d'incurver le cheminement de la lumière.

Un des buts de l'invention est aussi de proposer une structure de guide qui permette de réaliser des guides présentant une forte courbure, correspondant à un petit rayon de courbure.

C'est pourquoi la présente invention se propose de résoudre ces problèmes au moyen d'un dispositif tel que décrit dans le préambule et en outre caractérisé en ce que, la rainure pratiquée dans la couche dielectrique est formée avec une dimension transversale de l'ordre de 1 $\mu$m et faible devant la dimension transversale du guide, de manière à ce que des parties de la surface latérale du ruban prismatique soient en contact avec des parties de la couche diélectrique et à ce que ces parties de couche dielectrique participent, par leur surface que est grande devant celle de la rainure, au confinement de la lumière conjointement aux facettes cristallographiques formant des faces latérales du ruban prismatique.

Un des avantages de l'invention est que grâce à la méthode de croissance anisotrope utilisée on obtient directement la forme désirée pour le guide d'onde. Dans ces conditions, il n'est besoin d'effectuer aucune opération supplémentaire de gravure de la couche épitaxiale.

Un autre avantage de l'invention est que les rayons voient soit des facettes cristallographiques produisant la réflexion totale, soit principalement de part et d'autre de la rainure, la couche diélectrique qui est lisse et de faible indice par rapport au matériau semiconducteur formant le guide. Les rayons voient peu la rainure, vu le rapport des dimensions choisi et sont donc bien confinés dans le guide.

Selon une variante de l'invention, ce dispositif est remarquable en ce que le sillon prolongé jusque dans le substrat monocristallin s'étend aussi latéralement sous la couche diélectrique de part et d'autre de la rainure gravée dans la couche diélectrique produisant ainsi un sillon dit sous-gravé.

Selon une seconde variante de la présente invention, ce dispositif est remarquable en ce qu'une seconde couche diélectrique recouvre le fond de ce sillon sous-gravé mais non les facettes cristallines qui en constituent les flancs, et que le guide de lumière est formé à partir desdits flancs.

Dans ces différents dispositifs, les guides d'onde présentent des caractéristiques physiques analogues. Cependant, la réalisation du dispositif selon la seconde variante comprend une étape supplémentaire qui est le dépôt de la seconde couche d'oxyde de silicium. Mais, du fait de l'existence de cette dernière, la lumière est mieux confinée dans le guide d'onde et les pertes sont minimales.

Une diminution de l'influence du fond du sillon ou de la rugosité des faces latérales et supérieures du guide peut encore être obtenue par une autre variante de ce dispositif, remarquable en ce que le substrat est de type n, qu'une couche épitaxiale de type n plus fortement dopée que le substrat recouvre les faces latérales et le fond du sillon, que à partir de cette couche est formé le guide d'onde comportant une couche épitaxiale de type n plus faiblement dopée.

Pour l'application envisagée du couplage des fibres optiques aux circuits intégrés, le substrat semiconducteur monocristallin orienté et la couche épitaxiale sont constitués de composés du groupe III-V et en particulier d'arséniure de gallium, matériau favorable à la réalisaton de circuits intégrés ultrarapides. La couche diélectrique protectrice peut être par exemple en oxyde de silicium SiO$_2$ ou bien en nitrure Si$_3$N$_4$.

D'autre part, de tels guides de lumière présentent, sur leur parties laterales et sur leur partie supérieure, des facettes planes cristallographiques qui, étant donné la différence d'indice $\Delta n \simeq 2,5$ entre l'air et l'arséniure de gallium, permettent une réflexion totale quasi parfaite des rayons lumineux. Il s'ensuit que l'atténuation peut atteindre la valeur idéale de 1 dB/cm pour la longueur d'onde 1,06 $\mu$m.

C'est pourquoi la présente invention propose en outre un procédé de réalisation selon lequel les cristaux obtenus sont de taille et de forme contrôlées et parfaitement reproductibles.

Les particularités et les modes de réalisation conformes à l'invention apparaissent de façon plus précise dans la description qui va suivre, en regard des figures annexées.

Les figures 1a et 1b représentent en coupe un guide d'onde réalisé en arséniure de gallium, obtenu, après gravure de la couche amorphe, par croissance sur le plan (1 0 0) du substrat et parallèlement à la direction [1, $\bar{1}$, 0] de ce plan.

Les figures 2a et 2b représentent en coupe, dans les conditions de la figure 1, un guide parallèle à la direction [1, 1, 0].

Les figures 3a et 3b représentent, dans les mêmes conditions, un guide orienté parallèlement à la direction [1, 0, 0].

La figure 4 représente, en coupe, un guide d'onde réalisé à partir d'une sous-gravure et d'un dépôt d'une couche amorphe sur le fond du sillon.

La figure 5 montre en coupe schématique un guide parallèle à la direction [1, 1, 0] réalisé à partir d'une sous-gravure dans un substrat de type n.

La figure 6 montre, vu du dessus, un guide d'onde dont le cheminement présente un rayon de courbure.

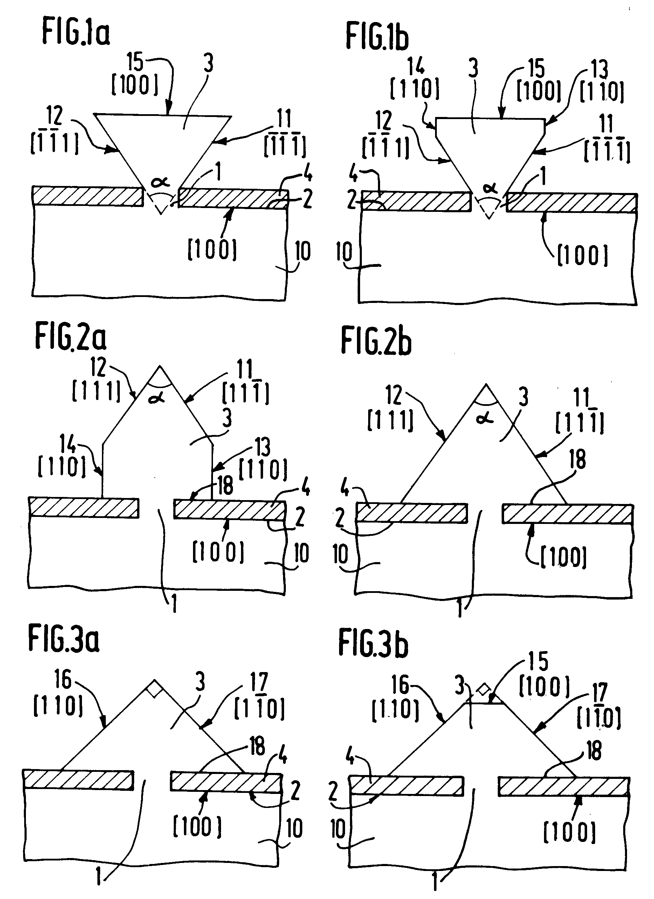

Dans une réalisation selon l'invention, et tel que représenté sur les figures 1 à 3 incluse, le substrat 10 de GaAs monocristallin, dont le plan de base 2 présente une orientation selon une face (1 0 0) du réseau cristallographique, est soumis à un polissage mécanochimique puis décapé. Une couche 4 de $SiO_2$, d'épaisseur 100 nm, est ensuite déposée sur la surface 2, par pyrolyse de $SiH_4$ en atmosphère d'oxygène, puis gravé jusqu'au substrat de manière à obtenir une rainure. La géométrie de la rainure suit le schéma prévu pour le guide de lumière et présente typiquement une largeur de 1 $\mu$m. La croissance du guide d'onde 3 à travers la rainure se fait par la méthode dite en phase vapeur aux chlorures à partir du substrat 10 utilisé comme amorce. Le mode opératoire dérive de celui qui est utilisé en épitaxie classique. Un décapage précède systématiquement la croissance, formant un sillon 1 plus ou moins profond dans le substraten prolongement de la rainure.

Différentes orientations du plan de base 2 du substrat 10 en GaAs sont possibles et permettent une croissance cristalline anisotrope du type cité précédemment. Le plan (1 0 0) a été choisi comme donnant les résultats les plus intéressants.

On note que la forme des guides d'onde obtenus dépend de l'orientation du sillon dans le plan (1 0 0). Les figures 1 à 3 illustrent bien ce phénomène. Suivant la direction cristallographique à laquelle le sillon est parallèle, la croissance produit des guides d'onde de formes différentes, présentant des facettes caractéristiques de la direction de croissance. La morphologie différente des figures de croissance résulte de l'incidence de la polarité du plan sur les vitesses de croissance.

Sur les figures 1a et 1b, où les sillons 1 sont parallèles à la direction [1, $\bar{1}$, 0], le guide d'onde 3 est limité par les faces latérales inclinées ($\bar{1}$ $\bar{1}$ $\bar{1}$) et

$\bar{1}$ $\bar{1}$ 1 ), numérotées 11 et 12, présentant entre elles un angle $\alpha$ de 70°, 53', ainsi que éventuellement par les faces latérales verticales (1 1 0) numérotées 13 et 14, et enfin par une face supérieure horizontale (1 0 0), parallèle au plan de base 2, et numérotée 15. La forme générale de la section droite du guide est un triangle isocèle dont le sommet est tourné vers le bas.

Sur les figures 2a et 2b, où le sillon 1 est parallèle à la direction [1, 1, 0], le guide d'onde est limité par les faces latérales (1 1 0) verticales (eventuelles) numérotées 13 et 14, ainsi que par les faces latérales inclinées (1 1 1) et (1 1 $\bar{1}$) numérotées 11 et 12 présentant entre elles un angle $\alpha$ de 70° 53', et enfin par la face inférieure horizontale (1 0 0) numérotée 18. La forme générale de la section droite du guide est un triangle isocèle dont le pointe est dirigée vers le haut.

Sur les figures 3a et 3b, où le sillon est orienté parallèlement à la direction [1, 0, 0], le guide est limité par les faces latérales inclinées (1 1 0) et (1 $\bar{1}$ 0) numérotées 16 et 17, perpendiculaires entre elles, et éventuellement par une face supérieure horizontale (1 0 0), numérotée 15. La forme générale du guide d'onde est un triangle isocèle rectangle dont le sommet est dirigé vers le haut.

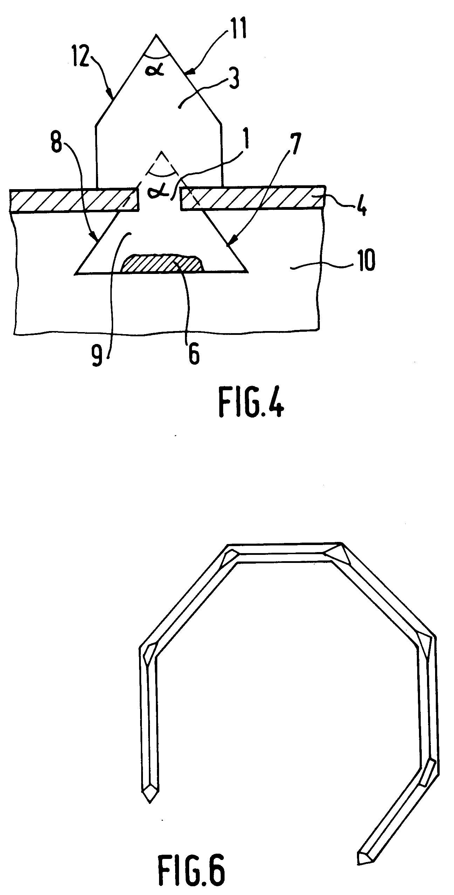

La figure 4 montre la section droite d'un guide réalisé à partir d'une sous-gravure. La première couche 4 de silice $SiO_2$ est déposée en phase vapeur puis gravée. La gravure est prolongée dans le substrat latéralement de part et d'autre de la rainure gravée dans la couche diélectrique. Elle y produit un sillon 9 dit sous-gravé, dont les flancs 7 et 8 et le fond sont des facettes cristallographiques dues au fait que le substrat 10 est monocristallin et orienté. La seconde couche 6 de $SiO_2$ est obtenue par évaporation sous vide. Ce sont les facettes des flancs 7 et 8 du sillon sous-gravé 9 qui guident l'armorce de cristallisation anisotrope permettant la réalisation du guide d'onde 3. La forme finale de ce dernier dépend de ces facettes 7 et 8, donc également de la direction cristallographique à laquelle le sillon est parallèle.

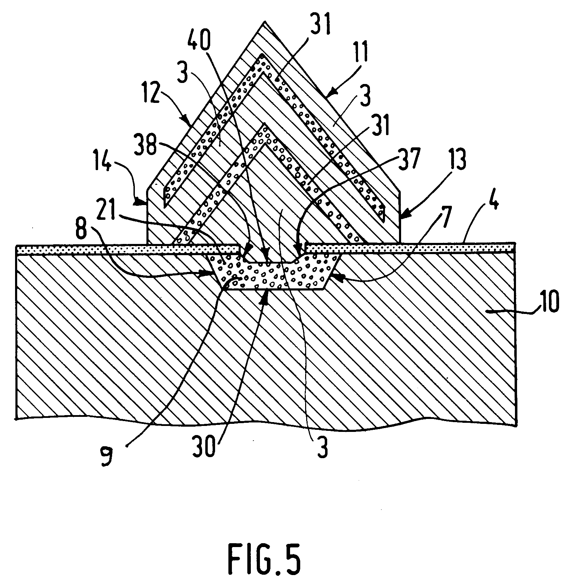

La figure 5 montre en coupe schématique un guide d'onde réalisé à partir d'un substrat 10 semiconducteur monocristallin orienté (1 0 0) de type $n^-$, recouvert d'une couche diélectrique 4 en nitrure $Si_3N_4$. Le sillon sous-gravé 9 présente des facettes 7 et 8, respectivement (1 1 1) et (1 1 $\bar{1}$), caractéristiques de son orientation parallèlement à la direction [1, 1, 0] et le fond (1 0 0) numerate 30. Une couche épitaxiale 21 de GaAs $n^+$ est formée sur le fond 30 et les faces latérales 7 et 8 de ce sillon 9. Puis le guide d'onde proprement dit 3 est formé par croissance épitaxiale de GaAs-$n^-$ à partir des faces 37, 38 et du fond 40 de la couche précédente. Le guide d'onde 3 peut encore être recouvert d'une ou plusieurs couches épitaxiales 31 de GaAs $n^+$ alternées avec des couches épitaxiales de GaAs $n^-$.

Dans les cas décrits précédemment aux Fig. 1 à 3 le trajet des rayons lumineux s'effectue principalement dans la partie 3 du guide d'onde érigée au-dessus de la couche 4 de $SiO_2$ ou $Si_3N_4$. Les rayons lumineux voient peu la face supérieure du substrat 10 en GaAs dans le fond du sillon, compte tenu des rapports de surface. Dans le cas du sillon sous-gravé 9 présenté sur la figure 4, au lieu du fond du sillon 9, les rayons voient la couche 6 de $SiO_2$, et non pas les flancs 7 et 8. Ils subissent donc une réflexion totale, et les pertes sont de ce fait encore légèrement diminuées, sans que la technologie devienne beaucoup plus complexe. Dans le cas des guides obtenus par modulation de dopage, présenté sur la figure 5, les différences d'indice entre le GaAs de type $n^-$ et le GaAs de type $n^+$, permettent le confinement de la lumière dans le GaAs de type $n^-$. Il a été mesuré dans le tels guides une perte intrinsèque de 1,5 dB/cm.

Dans une variante non illustrée du guide d'onde de la figure 5, le sillon sous-gravé peut être prévu de grandes dimensions. Si le substrat est semi-isolant, une couche de confinement de type $n^+$ est réalisée puis le guide d'onde proprement dit est formé par croissance épitaxiale de GaAs de type $n^-$ à partir des faces 37, 38 et du fond 40 de la couche deconfinement. Mais la croissance est stoppée lorsque le guide atteint le niveau de la couche diélectrique 4. La rainure peut alors être fermée par la superposition de couches épitaxiales GaAs $n^+$ et $n^-$ alternées. Au contraire si le substrat est de type $n^+$, alors le guide d'onde peut être réalisé directement dans le sillon sous-gravé par croissance de GaAs de type $n^-$. Il peut être ensuite terminé comme précédemment. D'une façon générale, pour un bon confinement de la lumière, les couches de confinement doivent être $n^+$ alors que le guide doit être de type $n^-$. Dans une telle réalisation le guide d'onde est donc entièrement confiné dans le substrat. Cette réalisation est décrite à titre d'exemple de facilité d'utilisation du procédé selon l'invention.

Dans ces conditions de pertes minimales et de lumière très bien confinée, on peut envisager pour les guides d'onde lumineuse réalisés selon l'invention des trajets à la fois longs et présentant des courbures accentuées.

A titre d'exemple, la figure 6 représente, vu du dessus, un guide d'onde présentant un rayon de courbure. La croissance d'un tel guide est permise par la réalisation initiale de plusieurs tronçons de sillons d'orientation cristallographique différente, réalisés à la suite les uns des autres, selon le tracé d'une ligne brisée.

Les excellentes performances de tels guides d'onde et la souplesse des possibilités de réalisation technologiques permettent d'envisager pour ces dispositifs une gamme d'applications étendue, tout particulièrement lorque le substrat est choisi en arséniure de gallium. En effet ce matériau permet la réalisation de circuits intégrés ultrarapides. Les circuits d'optoélectronique intégrés monolithiquement sur arséniure de gallium promettent donc de très grandes vitesses.

Quelques applications déjà réalisées peuvent être citées à titre d'exemple.

Tout d'abord le couplage de fibres optiques conventionnelles avec des diodes électroluminescentes réalisées conjointement sur un substrat en arséniure de gallium avec des guides d'onde selon l'invention.

Ensuite la modulation de la lumière transportée par de tels guides, cette modulation étant obtenue par le moyen de circuits réalisés sur le même substrat;

Dans ces exemples d'application le domaine de l'invention est principalement celui des longueurs d'onde situées entre 0,9 $\mu m$ et 1,06 $\mu m$, la fenêtre se trouvant typiquement entre 1,03 et 1,55 $\mu m$.

On notera que la croissance épitaxiale à partir du substrat monocristallin orienté, pris comme amorce, peut être faite, non seulement en utilisant le même matériau que le substrat, mais encore en utilisant tout autre matériau dont les paramètres de maille cristallographique sont compatibles avec les paramètres de maille du substrat.

On notera également que, lors de l'élaboration d'un guide d'onde selon l'une quelconque des mises en oeuvre de l'invention, il se forme à l'extrémité du guide des facettes formant un prisme, et que ce dernier peut être utilisé pour obtenir par réflexion totale, l'introduction ou l'extraction de la lumière dans le guide d'onde par la face arrière du substrat.

## Revendications

1. Dispositif semiconducteur incluant un guide de lumière intégré, ce dispositif comprenant un substrat semiconducteur monocristallin (10) ayant une surface (2) orientée selon un plan cristallographique, recouverte d'une couche diélectrique (4) munie d'une ouverture en forme de rainure parallèle à une direction cristallographique du substrat, ladite ouverture étant prolongée dans le substrat par un sillon (1;9) ayant au moins une paroi (7,8) formée par une facette cristallographique et ledit dispositif comprenant en outre pour constituer le guide de lumière un ruban (3) épitaxial monocristallin semiconducteur réalisé par croissance à partir de la facette cristallographique du sillon, ledit ruban ayant une forme prismatique d'axe parallèle à la direction du sillon et des faces (11-17) qui sont des facettes cristallographiques naturelles de croissance du ruban épitaxial, caractérisé en ce que la rainure pratiquée dans la couche dielectrique est formée avec une dimension transversale de l'ordre de 1 $\mu$m et faible devant la dimension transversale du guide, de manière à ce que des parties de la surface latérale du ruban prismatique soient en contact avec des parties de la couche diélectrique et à ce que ces parties de couche dielectrique participent, par leur surface qui est grande devant celle de la rainure, au confinement de la lumiere conjointement aux facettes cristallographiques formant des faces latérales du ruban prismatique.

2. Dispositif semiconducteur selon la revendication 1, caractérisé en ce que le sillon prolongé jusque dans le substrat monocristallin s'étend aussi latéralement sous la couche diélectrique de part et d'autre de la rainure gravée dans la couche diélectrique, produisant ainsi un sillon (9) dit sous-gravé.

3. Dispositif semiconducteur selon la revendication 2, caractérisé en ce qu'une seconde couche diélectrique (6) recouvre le fond de ce sillon sous-grave (9) mais non les facettes cristallines (7,8) qui en constituent les flancs, et que le guide de lumière est formé à partir desdits flancs.

4. Dispositif selon la revendication 2, caractérisé en ce que le substrat (10) est de type n, qu'une couche épitaxiale de type n plus fortement dopée que le substrat recouvre les faces latérales et le fond du sillon (9), et en ce que le guide d'onde est constitué d'une couche épitaxiale de type n plus faiblement dopée.

5. Dispositif selon l'une des revendications 1 à 4, caractérisé en ce que le guide de lumière est érigé du côté opposé au substrat par rapport à la couche diélectrique et confiné par les parties de surface de la couche diélectrique opposées au substrat.

6. Dispositif selon la revendication 4, caractérisé en ce que le guide de lumière est enterré dans le sillon et confiné par les parties de surface de la couche diélectrique regardant le substrat.

7. Dispositif semiconducteur selon l'une des revendications 5 ou 6, caractérisé en ce qu'en surface, le guide d'onde comporte une structure stratifiée de couches épitaxiales alternativement de faible et fort indice, se terminant par une couche de faible indice.

8. Dispositif semiconducteur selon l'une des revendications 1 à 7, caractérisé en ce que le matériau des couches diélectriques est de l'oxyde ou du nitrure de silicium.

9. Dispositif selon l'une des revendications 1 à 8, caractérisé en ce que, pour que le guide d'onde lumineuse soit adapté à la propagation de lumière dans le domaine des longueurs d'onde situé entre 0,9 et 1,06 $\mu$m, le substrat et la ou les couches épitaxiales sont en un matériau semiconducteur monocristallin orienté du groupe III-V et en ce que la surface orientée du substrat est parallèle au plan (1 0 0) du réseau cristallin.

10. Procédé de réalisation d'un dispositif semiconducteur selon l'une des revendications 1 à 9, caractérisé en ce qu'il comprend les étapes de :
    - déposition d'une couche diélectrique (4) sur une face cristalline (2) d'un substrat (10) semiconducteur monocristallin,
    - formation d'une ouverture en forme de rainure de dimension transversale de l'ordre de 1 $\mu$m, par gravure dans la couche diélectrique parallèlement à une direction cristallographique du substrat,
    - prolongation, par gravure anisotrope, de la rainure pour former un sillon (1;9) dans le substrat monocristallin, ce sillon présentant au moins une paroi formée par une facette cristallographique,
    - formation par croissance par la méthode dite en phase vapeur aux chlorures d'une couche épitaxiale à partir de la facette cristallographique du sillon, cette croissance épitaxiale monocristalline semiconductrice produisant un ruban prismatique (3) d'axe parallèle à la direction du sillon, dont les faces (11-17) sont des facettes cristallographiques naturelles de croissance, et de diamètre approprié à constituer un guide d'onde lumineuse et supérieur à 1 $\mu$m.

11. Procédé selon la revendication 10, caractérisé en ce que la gravure anisotrope du substrat monocristallin orienté s'étend aussi latéralement sous la couche diélectrique de part et d'autre de la rainure gravée dans la couche diélectrique, produisant ainsi un sillon sous-gravé (9) dans le substrat.

12. Procédé selon la revendication 11, caractérisé en ce qu'une seconde couche (6) d'un matériau diélectrique est déposée sur cet ensemble, venant couvrir le fond du sillon sous-gravé, mais non les flancs, qui se trouvent à l'ombre de la première couche diélectrique protectrice, et en ce que le guide de lumière est réalisé par croissance anisotrope à partir des facettes cristallines (7,8) constituant les flancs du sillon sous-gravé.

13. Procédé selon la revendication 11, caractérisé en ce que premièrement le substrat semiconducteur monocristallin orienté est choisi de type n, en ce que deuxièmement une couche épitaxiale d'un matériau semiconducteur de type n plus fortement dopée que le substrat est formée sur les faces latérales et le fond du sillon, en ce que enfin le guide d'onde est formé, à partir du sillon ainsi préparé, par croissance épitaxiale d'un matériau semiconducteur de type n moins fortement dopée que la précédente couche.

14. Procédé selon l'une des revendications 10 à 13, caractérisé en ce que le ruban prismatique est disposé du côté opposé au substrat par rapport à la couche diélectrique pour former un guide érigé.

15. Procédé selon la revendication 13, caractérisé en ce que la croissance de la couche épitaxiale est limitée au sillon sous gravé pour former un guide enterré.

16. Procédé selon l'une des revendications 10 à 15, caractérisé en ce que en surface du guide d'onde sont réalisées une ou plusieurs couches épitaxiales de matériau semiconducteur de faible indice alternées avec des couches de fort indice en terminant par une couche de faible indice.

**Claims**

1. A semiconductor device with an integrated optical waveguide, which device comprises a monocrystalline semiconductor substrate (10) having a surface (2) oriented according to a crystallographic plane and covered by a dielectric layer (4) provided with an opening in the shape of a groove parallel to a crystallographic direction of the substrate, the said opening being prolonged in the substrate by a channel (1, 9) having at least one wall (7, 8) formed by a crystallographic facet, and which device comprises in addition a monocrystalline epitaxial semiconductor ribbon (3) for forming the optical waveguide, realised by growth from the crystallographic facet of the channel, the said ribbon having a prismatic shape with an axis parallel to the direction of the channel and surfaces (11, 17) which are natural crystallographic growth facets of the epitaxial ribbon, characterized in that the groove provided in the dielectric layer is formed with a transversal dimension of the order of 1 $\mu$, small in comparison with the transversal dimension of the waveguide, in such a manner that portions of the lateral surface of the prismatic ribbon are in contact with portions of the dielectric layer and that these portions of the dielectric layer take part, by means of their surface which is large compared with that of the groove, in the confinement of the light in conjunction with the crystallographic facets forming the lateral surfaces of the prismatic ribbon.

2. A semiconductor device as claimed in Claim 1, characterized in that the channel which is prolonged to in the monocrystalline substrate also extends laterally below the dielectric layer on either side of the etched groove in the dielectric layer, thus producing a so-called under-etched channel (9).

3. A semiconductor device as claimed in Claim 2, characterized in that a second dielectric layer (6) covers the bottom of the said under-etched channel (9), but not the crystal facets (7, 8) which constitute the flanks thereof, and in that the optical waveguide is formed on the basis of the said flanks.

4. A semiconductor device as claimed in Claim 2, characterized in that the substrate (10) is of the n-type, in that an epitaxial layer of the n-type which is more highly doped than the substrate covers the lateral surfaces and the bottom of the channel (9), and in that the waveguide is formed from a more weakly doped epitaxial n-type layer.

5. A device as claimed in any one of the Claims 1 to 4, characterized in that the optical waveguide is constructed at the opposite side of the substrate relative to the dielectric layer and confined by surface portions of the dielectric layer which are opposite the substrate.

6. A device as claimed in Claim 4, characterized in that the optical waveguide is buried in the channel and confined by surface portions of the dielectric layer facing the substrate.

7. A semiconductor device as claimed in one of the Claims 5 and 6, characterized in that at the surface the waveguide comprises a stratified structure of alternating epitaxial layers of low and high refractive index, ending with a layer of low refractive index.

8. A semiconductor device as claimed in any one of the Claims 1 to 7, characterized in that the material of the dielectric layers is silicon oxide or silicon nitride.

9. A device as claimed in any one of the Claims 1 to 8, characterized in that, so as to render the optical waveguide suitable for the propagation of light in the wavelength range between 0,9 and 1,06 $\mu$m, the substrate and the epitaxial layer(s) are made of an oriented monocrystalline semiconductor material from the group III-V, and in that the oriented surface of the substrate is parallel to the plane (1 0 0) of the crystal lattice.

10. A method of manufacturing a semiconductor device as claimed in any one of the Claims 1 to 9, characterized in that it comprises the following steps:
   - deposition of a dielectric layer (4) on a crystalline surface (2) of a substrate (10),
   - formation of an opening in the form of a groove having a transverse dimension of the order of 1 $\mu$, by etching into the dielectric layer parallel to a crystallographic direction of the substrate,
   - prolongation by anisotropic etching of the groove so as to form a channel (1, 9) in the monocrystalline substrate, which channel has at least one wall which is formed by a crystallographic facet,
   - formation through growth by the so-called vapour-phase chloride method of an epitaxial layer based on the crystallographic facet of the channel, which epitaxial monocrystalline semiconductor growth produces a prismatic ribbon (3) having an axis parallel to the direction of the channel, the surfaces (11, 17) of which ribbon are natural crystallographic growth facets, and having a diameter suitable for forming an optical waveguide and larger than 1 $\mu$.

11. A method as claimed in Claim 10, characterized in that the anisotropic etching of the oriented monocrystalline substrate extends also in lateral direction under the dielectric layer on either side of the groove etched into the dielectric layer, thus producing an under-etched channel (9) in the substrate.

12. A method as claimed in Claim 11, characterized in that a second layer (6) of a dielectric material is deposited on this assembly, covering the bottom of the under-etched channel, but not the flanks which are situated in the shadow of the protecting first dielectric layer, and in that the optical waveguide is realised by anisotropic growth on the basis of the crystal facets (7, 8) forming the flanks of the under-etched channel.

13. A method as claimed in Claim 11, characterized in that firstly the oriented monocrystalline semiconductor substrate is chosen to be of the n-type, in that secondly an epitaxial layer of a semiconductor material of the n-type more highly doped than the substrate is formed on the lateral facets and the bottom of the channel, and in that finally the waveguide is formed on the basis of the channel thus prepared by epitaxial growth of a semiconductor material of the n-type less strongly doped than the preceding layer.

14. A method as claimed in any one of the Claims 10 to 13, characterized in that the prismatic ribbon is provided at the opposite side of the substrate relative to the dielectric layer so as to form a raised waveguide.

15. A method as claimed in Claim 13, characterized in that the growth of the epitaxial layer is limited to the under-etched channel so as to form a buried waveguide.

16. A method as claimed in any one of the Claims 10 to 15, characterized in that one or several epitaxial layers of a semiconductor material of low refractive index alternating with layers of high refractive index are realised at the surface of the waveguide, ending with a layer of low refractive index.

**Patentansprüche**

1. Halbleiteranordnung mit einem integrierten Lichtwellenleiter, wobei diese Anordnung ein monokristallines Halbleitersubstrat (10) mit einer entsprechend einer kristallographischen Ebene orientierten Fläche (2) aufweist und wobei dieses Substrat durch eine dielektrische Schicht (4) bedeckt ist, die eine Öffnung in Form einer Rille parallel zu einer kristallographischen Richtung des Substrats aufweist, wobei diese Öffnung in dem Substrat durch einen Kanal (1, 9) fortgesetzt wird, wobei wenigstens eine Wand (7, 8) dieses Kanals durch eine kristallographische Fläche gebildet wird, und wobei diese Anordnung außerdem ein monokristallines epitaxiales Halbleiterband (3) aufweist zum Bilden des Lichtwellenleiters, verwirklicht durch das Anwachsen aus der kristallographischen Fläche des Kanals, wobei dieses Band eine prismatische Form hat mit einer Achse parallel zu der Kanalrichtung und mit Flächen (11 - 17), die natürliche Wachstumsflächen des epitaxialen Bandes sind, dadurch gekennzeichnet, daß die in der dielektrischen Schicht gebildete Rille eine Querabmessung aufweist in der Größenordnung von 1 $\mu$m, was im Vergleich zu der Querabmessung des Wellenleiters gering ist, und zwar derart, daß Teile der Seitenwand des prismatischen Bandes Teile der dielektrischen Schicht berühren und daß diese Teile der dielektrischen Schicht mittels ihrer Oberfläche, die im Vergleich zu der der Rille groß ist, zusammen mit den kristallographischen Flächen, welche die Seitenflächen des prismatischen Bandes bilden, zu der Einschließung des Lichtes beitragen.

2. Halbleiteranordnung nach Anspruch 1, dadurch gekennzeichnet, daß der sich bis an das monokristalline Substrat erstreckende Kanal sich ebenfalls seitlich unterhalb der dielektrischen Schicht auf beiden Seiten der geätzten Rille in der dielektrischen Schicht erstreckt, wodurch auf diese weise ein sogenannter untergeätzter Kanal (9) entsteht.

3. Halbleiteranordnung nach Anspruch 2, dadurch gekennzeichnet, daß eine zweite dielektrische Schicht (6) den Boden des genannten untergeätzten Kanals (9) bedeckt, nicht aber die kristallinen Flächen (7, 8), welche die Flanken derselben bilden, und daß der Lichtwellenleiter ausgehend von den genannten Flanken gebildet wird.

4. Anordnung nach Anspruch 2, dadurch gekennzeichnet, daß das Substrat (10) vom n-Typ ist, daß eine n-leitende Epitaxialschicht, die höher dotiert ist als das Substrat, die Seitenwände und den Boden der Rille (9) bedeckt, und daß der Wellenleiter mit einer weniger dotierten, n-leitenden Epitaxialschicht gebildet wird.

5. Anordnung nach einem der Ansprüche 1 bis 4, dadurch gekennzeichnet, daß der Lichtwellenleiter auf der dem Substrat gegenüberliegenden Seite gegenüber der dielektrischen Schicht abgehoben und durch diejenigen Teile der dielektrischen Schicht, die dem Substrat gegenüberliegen, eingeschlossen ist.

6. Anordnung nach Anspruch 4, dadurch gekennzeichnet, daß der Lichtwellenleiter in der Rille vergraben ist und durch die Teile der Oberfläche der dielektrischen Schicht eingeschlossen ist, die dem Substrat zugewandt sind.

7. Halbleiteranordnung nach einem der Ansprüche 5 oder 6, dadurch gekennzeichnet, daß der Wellenleiter auf der Oberfläche eine Lagenstruktur von Schichten mit abwechselnd niedriger und hoher Brechzahl aufweist, endend mit einer Schicht niedriger Brechzahl.

8. Halbleiteranordnung nach einem der Ansprüche 1 bis 7, dadurch gekennzeichnet, daß das Material der dielektrischen Schichten Siliziumoxid oder Siliziumnitrid ist.

9. Anordnung nach Anspruch 1 bis 8, dadurch gekennzeichnet, daß das Substrat und die epitaxiale(n) Schicht(en) aus einem monokristallinen orientierten Halbleitermaterial der Gruppe III-V bestehen, und daß die orientierte Oberfläche des Substrats sich parallel zu der Ebene (1 0 0) des Kristallgitters erstreckt, damit der Lichtwellenleiter an die Fortpflanzung von Licht im Wellenlängenbereich zwischen 0,9 und 1,06 $\mu$m angepaßt ist.

10. Verfahren zum Herstellen einer Halbleiteranordnung nach einem der Ansprüche 1 bis 9, dadurch gekennzeichnet, daß dieses Verfahren die nachfolgenden Verfahrensschritte aufweist:
   - das Niederschlagen einer dielektrischen Schicht (4) auf einer kristallinen Fläche (2) eines monokristallinen Halbleitersubstrats (10),
   - das Bilden einer Öffnung in Form einer Rille mit einer Querabmessung in der Größenordnung von 1 $\mu$m durch Ätzung in der dielektrischen Schicht parallel zu einer kristallographischen Richtung des Substrats,
   - Fortsetzung durch anisotrope Ätzung der Rille zum Bilden eines Kanals (1, 9) in dem monokristallinen Substrat, wobei dieser Kanal mindestens eine durch eine kristallographische Fläche gebildete Wand aufweist,
   - Bildung einer Epitaxialschicht durch Ätzung im sog. Chloriddampfphase-Verfahren, ausgehend von der kristallographischen Fläche des Kanals, wobei dieses epitaxiale monokristalline Halbleiter-Aufwachsen ein prismatisches Band (3) ergibt, dessen Achse sich parallel zu der Kanalrichtung erstreckt, wobei die Flächen (11 - 17) natürliche kristallographische Wachstumsflächen sind und mit einem Durchmesser, der zum Bilden eines Lichtwellenleiters geeignet und größer als 1 μm ist.

**11.** Verfahren nach Anspruch 10, dadurch gekennzeichnet, daß die anisotrope Ätzung des monokristallinen orientierten Substrats sich ebenfalls seitlich unterhalb der dielektrischen Schicht auf beiden Seiten der in der dielektrischen Schicht geätzten Rille erstreckt, wodurch ebenfalls ein untergeätzter Kanal (9) in dem Substrat gebildet wird.

**12.** Verfahren nach Anspruch 11, dadurch gekennzeichnet, daß auf diesem Gefüge eine zweite Schicht (6) aus einem dielektrischen Material niedergeschlagen wird, die den Boden, nicht aber die Flanken des untergeätzten Kanals bedeckt, die sich im Schatten der sehützenden ersten dielektrischen Schicht liegen, und daß der Lichtwellenleiter durch anisotropes Aufwachsen, ausgehend von den kristallinen Flächen (7, 8), welche die Flanken des untergeätzten Kanals bilden, erhalten wird.

**13.** Verfahren nach Anspruch 11, dadurch gekennzeichnet, daß erstens das orientierte monokristalline Halbleitersubstrat als n-leitend gewählt worden ist, daß zweitens eine Epitaxialschicht aus einem n-leitenden Halbleitermaterial, das stärker dotiert ist als das Substrat, auf den Seitenflächen und auf dem Boden des Kanals gebildet wird, daß zum Schluß der Wellenleiter gebildet wird, ausgehend von dem auf diese Weise vorbereiteten Kanal, durch epitaxiales Aufwachsen eines n-leitenden Halbleitermaterials, das weniger stark dotiert ist als die vorhergehende Schicht.

**14.** Verfahren nach einem der Ansprüche 10 bis 13, dadurch gekennzeichnet, daß zum Bilden eines abgehobenen Wellenleiters das prismatische Band in bezug auf die dielektrische Schicht auf der dem Substrat gegenüberliegenden Seite vorgesehen ist.

**15.** Verfahren nach Anspruch 13, dadurch gekennzeichnet, daß das Aufwachsen der Epitaxialschicht zum Bilden eines vergrabenen Wellenleiters auf den untergeätzten Kanal beschränkt ist.

**16.** Verfahren nach einem der Ansprüche 10 bis 15, dadurch gekennzeichnet, daß auf der Oberfläche des Wellenleiters eine oder mehrere Epitaxialschichten aus Halbleitermaterial mit niedriger Brechzahl abwechselnd mit Schichten hoher Brechzahl angebracht werden, wobei diese Schichtung mit einer Schicht niedriger

Brechzahl endet.

# FIG.1a

15
[100]

3

12
[1̄11]

11
[111̄]

α

1

4

2

[100]

10

# FIG.1b

14
[11̄0]

3

15
[100]

13
[110]

12
[1̄11̄]

11
[1̄11̄]

4

2

α

1

10

[100]

# FIG.2a

12
[111]

α

11
[111̄]

14
[110]

3

13
[110]

18

4

2

[100]

10

1

# FIG.2b

12
[111]

α

3

11
[111̄]

18

4

2

10

[100]

1

# FIG.3a

16
[110]

3

17
[11̄0]

18

4

2

[100]

10

1

# FIG.3b

16
[110]

3

15
[100]

17
[11̄0]

4

18

2

10

[100]

1

FIG.4

FIG.6

FIG.5